# FASCICULE DE BREVET EUROPEEN

(11) **EP 1 902 600 B1**
(45) Date de publication et mention de la délivrance du brevet: **27.02.2013**
(21) Numéro de dépôt: 06794174.0
(22) Date de dépôt: 12.07.2006
(51) Int. Cl.: H05K 1/02

(54) **CIRCUIT IMPRIME PERFECTIONNE, ADAPTE A LA DETECTION D'UN ECHAUFFEMENT ACCIDENTEL**
VERBESSERTE BESTÜCKTE LEITERPLATTE MIT DER FÄHIGKEIT ZUR ERKENNUNG UNBEABSICHTIGTER ERHITZUNG
IMPROVED PRINTED CIRCUIT WHICH CAN DETECT ACCIDENTAL HEATING

(30) Priorité: 13.07.2005 FR 0507537
(43) Date de publication de la demande: 26.03.2008
(73) Titulaire: Valeo Electronique et Systèmes de Liaison, 78180 Montigny-le-Bretonneux (FR)
(72) Inventeur: SUZZONI, Etienne, F-95490 Vaurial (FR)
(74) Mandataire: de la Bigne, Guillaume Michel Marie
(86) Numéro de dépôt international: PCT/FR2006/001715
(87) Numéro de publication internationale: WO 2007/006980

(56) Documents cités:
- EP-A- 1 096 843
- FR-A- 2 733 099
- US-A- 4 956 561

## Description

La présente invention concerne un circuit imprimé perfectionné, adapté à la détection d'un échauffement accidentel.

Il est connu d'équiper un véhicule automobile avec un circuit imprimé comportant au moins un composant du type commutateur de puissance intelligent (en anglais, « smart power switch » ).

Le circuit imprimé comprend un support isolant dans les conditions normales de fonctionnement du circuit imprimé. En général, le support est formé dans un matériau comprenant, par exemple, de la résine époxy.

De façon classique, un commutateur de puissance intelligent comprend deux rangées de broches de connexion. Une des deux rangées comprend des broches de sortie destinées à être raccordées à un circuit électrique pour l'alimentation des organes électriques du véhicule automobile.

Du fait que les intensités des courants en sortie des broches peuvent être relativement élevées, le composant est susceptible de provoquer un échauffement indésirable d'une zone du support proche de la rangée des broches de sortie.

Un échauffement trop important de la zone du support peut notamment déclencher un départ de feu.

Pour pouvoir prévenir d'un risque de départ de feu, on a proposé dans l'état de la technique, notamment dans les documents EP 1 096 843 ou FR 2 733 099, un circuit imprimé comprenant un support, isolant dans les conditions normales de fonctionnement du circuit imprimé, portant au moins un composant susceptible de provoquer accidentellement un échauffement indésirable d'une zone sensible du support, et des moyens de détection de l'échauffement de la zone sensible.

En général, les moyens de détection comprennent un thermo-détecteur comprenant une thermistance.

De façon connue en soi, une thermistance est un composant thermosensible dont la valeur de la résistance varie avec sa température.

Ainsi, en plaçant la thermistance sur le circuit imprimé à proximité du composant, il est possible de détecter une élévation de température du composant et donc de la zone du support à proximité du composant, en suivant les variations de la valeur de la résistance de la thermistance.

Par ailleurs, par souci d'efficacité, on positionne la thermistance de préférence à une distance aussi faible que possible du composant.

La thermistance de détection de l'échauffement augmente donc l'encombrement du circuit imprimé dans l'environnement du composant.

L'encombrement du circuit imprimé est d'autant plus important que le nombre de composants à surveiller est grand car il est nécessaire d'associer une thermistance à chaque composant susceptible de provoquer un échauffement indésirable du support.

L'invention a pour but de proposer un circuit imprimé perfectionné du type précité, adapté à la détection d'un échauffement accidentel, susceptible de prévenir et/ou détecter efficacement un départ de feu, ceci à l'aide de moyens simples et peu encombrants.

A cet effet, l'invention a pour objet un circuit imprimé tel que divulgué dans la revendication 1.

Ainsi, l'invention utilise directement la variation de la conductivité du support plutôt que la variation de la conductivité d'un composant (thermistance) rapporté sur le support.

En effet, dans les conditions normales de fonctionnement du circuit imprimé, le support est isolant.

Lors d'un échauffement accidentel du composant, la température de la zone sensible du support à proximité du composant augmente. Au-delà d'un seuil de température dépendant notamment du matériau formant le support, le support devient notablement conducteur.

Ce seuil est d'environ 300°C, pour un support à base de résine époxy.

La détection, localement, d'une élévation importante de la conductivité du support permet donc de mettre en évidence un risque de départ de feu.

Les moyens sensibles comprennent un premier élément conducteur, dit de référence, porté à un potentiel de référence dans les conditions normales de fonctionnement du circuit imprimé et au moins un second élément conducteur porté à un potentiel différent du potentiel de référence. Les premier et second éléments s'étendent au moins partiellement dans la zone sensible.

En cas d'échauffement important de la zone sensible, le premier élément conducteur est en contact électrique avec le second élément conducteur.

De ce fait, la valeur du potentiel du premier élément conducteur varie à la baisse ou à la hausse selon la valeur du potentiel du second élément conducteur.

Il est alors possible de détecter un échauffement de la zone sensible du support en suivant les variations de potentiel du premier élément conducteur.

A cet effet, les moyens sensibles comprennent des moyens de mesure du potentiel du premier élément conducteur et des moyens de comparaison du potentiel du premier élément conducteur avec le potentiel de référence.

Le circuit imprimé selon l'invention peut en outre comporter l'une ou plusieurs des caractéristiques suivantes :
- le second élément conducteur est une piste d'alimentation du composant portée à un potentiel d'alimentation du composant ;
- le composant comporte une semelle formant borne d'alimentation soudée sur la piste d'alimentation ;
- l'élément conducteur de référence s'étend longitudinalement entre un bord rectiligne de la piste d'alimentation et une rangée de broches de connexion du composant ;
- les moyens sensibles comprennent des moyens de comparaison du potentiel du premier élément conducteur avec le potentiel de référence ;
- le potentiel de référence est égal à la moitié du potentiel d'alimentation du composant électronique ;
- le support portant un groupe de composants susceptibles de provoquer accidentellement un échauffement de plusieurs zones sensibles, le premier élément conducteur de référence comprend plusieurs branches s'étendant respectivement dans les différentes zones sensibles du support ;
- le support est formé dans un matériau comprenant de la résine époxy ;
- le composant est un commutateur de puissance intelligent comprenant des première et seconde rangées de broches de connexion, la première rangée comprenant des broches d'entrée et la seconde rangée comprenant des broches de sortie, la zone sensible s'étendant plus près de la seconde rangée que de la première rangée ;
- le second élément est un élément conducteur formant une broche de connexion du composant à une masse ou une broche de sortie ;
- le support portant un groupe de composants susceptibles de provoquer accidentellement un échauffement de plusieurs zones sensibles, les moyens de détection comprennent plusieurs moyens sensibles associés respectivement aux différentes zones sensibles du support ;
- chacun des moyens sensibles à l'élévation de la conductivité du support est destiné à être raccordé à des moyens informatiques afin notamment d'identifier, parmi les différents composants portés par le support du circuit imprimé, le groupe de composants ou le composant qui est responsable d'un échauffement indésirable d'une zone sensible du support.

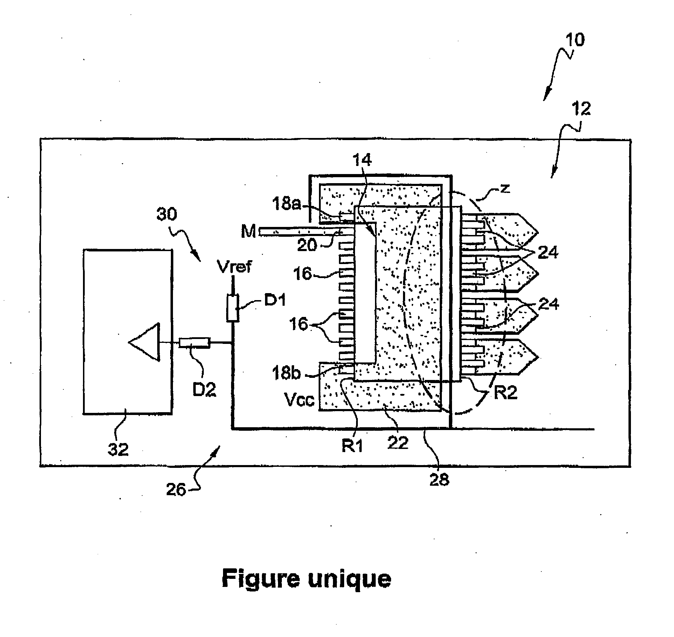

L'invention sera mieux comprise à la lecture de la description qui va suivre, donnée uniquement à titre d'exemple et faite en se référant aux dessins dans lesquels la figure unique est un schéma d'un circuit imprimé selon l'invention.

On a représenté sur la figure un circuit imprimé selon l'invention, désigné par la référence générale 10.

Le circuit imprimé 10 comprend un support 12 qui est isolant dans les conditions normales de fonctionnement du circuit imprimé 10.

Dans l'exemple décrit, le support 12 est formé dans un matériau comprenant de la résine époxy. De ce fait, le support 12, isolant aux températures normales de fonctionnement du circuit imprimé, devient notablement conducteur pour des températures supérieures à environ 300°C.

Le circuit imprimé 10 porte un composant 14. Dans l'exemple décrit, le composant 14 est de type commutateur de puissance intelligent (en anglais, « smart power switch »). En variante, le composant 14 peut être une borne d'une alimentation, une résistance, un transistor, un relais ou tout autre composant susceptible de provoquer un échauffement indésirable d'une zone du support 12.

En général, un composant du type commutateur de puissance intelligent comprend une première R1 et une seconde R2 rangées de broches de connexion.

La première rangée R1 comprend des broches d'entrée 16, des broches d'alimentation 18a, 18b et une broche 20 raccordée à une masse M. Les bornes d'entrée 16 sont destinées à être raccordées, par exemple, à un micro-contrôleur (non représenté) pour le pilotage du composant 14.

Par ailleurs, les broches d'alimentation 18a, 18b sont raccordées entre elles électriquement par une piste 22 d'alimentation du composant 14, portée à un potentiel d'alimentation Vcc.

De façon classique, le composant 14 comprend une semelle rectangulaire, formant borne d'alimentation, soudée à la piste d'alimentation 22.

En général, la semelle est formée dans un matériau métallique et est destinée également à dissiper l'énergie thermique générée au cours du fonctionnement du composant 14.

La seconde rangée R2 comprend des bornes de sortie 24. Les bornes 24 sont destinées, par exemple, à être raccordées à un circuit électrique pour l'alimentation d'un organe électrique d'un véhicule automobile (non représenté).

En général, le composant 14 génère des courants forts en sortie des bornes 24. Ainsi, le composant 14 est susceptible de provoquer accidentellement un échauffement indésirable d'une zone sensible Z du support 12. La zone sensible Z s'étend plus près de la seconde rangée R2 que de la première rangée R1.

Afin de détecter un échauffement accidentel dans la zone sensible Z, le circuit imprimé 10 comprend des moyens de détection d'un échauffement de la zone sensible Z.

En particulier, le support 12 étant formé dans un matériau comportant de la résine époxy, la zone sensible Z devient conductrice au moins localement pour des températures supérieures à environ 300°C.

Les moyens de détection comprennent donc des moyens 26 sensibles à l'élévation de la conductivité du support 12 avec la température.

Les moyens sensibles 26 comprennent un premier élément conducteur, dit de référence, porté, dans les conditions normales de fonctionnement du circuit imprimé 10, à un potentiel de référence Vref et au moins un second élément conducteur porté à un potentiel différent du potentiel de référence Vref.

Les premier et second éléments conducteurs s'étendent au moins partiellement dans la zone sensible Z.

Dans l'exemple décrit, le premier élément conducteur est une piste classique 28, dite piste de référence, du circuit imprimé 10 et le second élément conducteur est la piste d'alimentation 22.

De préférence, la piste de référence 28 s'étend longitudinalement entre un bord rectiligne de la piste d'alimentation 22 et la rangée R2 du composant 14 comportant les broches 24 de connexion du composant 14 au circuit électrique (non représenté) à alimenter.

Dans la zone sensible Z, la distance entre la piste 28 et la piste d'alimentation 22 est déterminée par l'homme du métier en fonction des contraintes d'encombrement et d'intensité de courant.

Ainsi, dans les conditions normales de fonctionnement du circuit imprimé 10, les pistes 28 et 22 sont isolées électriquement. Par contre, lors d'un échauffement accidentel de la zone Z, notamment pour une température supérieure à environ 300°C, l'augmentation locale de la conductivité du support 12 crée une jonction électrique entre les deux pistes 28 et 22.

En variante, le second élément conducteur peut être un élément conducteur formant une broche de connexion 16, 20, 18a, 18b, ou une broche de sortie 24 du composant 14.

Le potentiel de la piste de référence 28, ayant une valeur égale au potentiel de référence Vref dans les conditions normales de fonctionnement du circuit imprimé 10, varie du fait de l'apparition de la jonction électrique entre les deux pistes 28 et 22.

L'invention permet de détecter un échauffement de la zone sensible Z du support 12 en suivant les variations du potentiel de la piste de référence 28.

A cet effet, les moyens sensibles 26 comprennent encore des moyens 30 de mesure du potentiel de la piste de référence 28. Dans l'exemple décrit, les moyens de mesure 30 comprennent un pont diviseur de tension comportant deux dipôles résistifs D1, D2.

Par ailleurs, les moyens sensibles 26 comprennent encore des moyens 32 de comparaison de ce potentiel avec le potentiel de référence Vref.

Ainsi, lorsque le potentiel de la piste de référence 28 varie, il est possible de détecter une augmentation de conductivité dans la zone Z et donc un échauffement de cette zone Z.

De préférence, le potentiel de référence Vref a pour valeur la moitié du potentiel d'alimentation Vcc. Ainsi, en cas de raccordement électrique par augmentation locale de la température et de la conductivité du support 12 entre la piste de référence 28 et la piste d'alimentation 22, le potentiel de la piste de référence 28 augmente.

En revanche, dans le cas où l'échauffement se produit dans une zone du support proche de la broche 20 raccordée à la masse M, le potentiel de la piste de référence 28 diminue.

On décrira ci-dessous les principaux aspects du fonctionnement du circuit imprimé 10 liés à l'invention.

Dans les conditions normales de fonctionnement du circuit imprimé 10, le support 12 est isolant et la piste de référence 28 est portée à un potentiel Vref.

Lors d'un échauffement accidentel de la zone sensible Z, notamment lorsque la zone Z du support 12 atteint une température supérieure à 300°C, le support 12 devient conducteur dans la zone d'échauffement Z.

Ainsi, la piste de référence 28 est susceptible d'être raccordée, par augmentation locale de la conductivité du support 12, à la piste d'alimentation 22, une broche de sortie 24 ou encore à la broche 20 raccordée à la masse M.

Le potentiel de la piste de référence 28 varie en fonction du potentiel du second élément conducteur avec lequel la jonction électrique est établie.

Les moyens 30 mesurent le potentiel de la piste 28 et les moyens 32 comparent la valeur de ce potentiel avec le potentiel de référence Vref.

Ainsi, lorsque la piste de référence 28 est raccordée, par augmentation locale de la conductivité du support 12, avec la piste d'alimentation 22, le potentiel de la piste de référence 28 augmente.

En revanche, lorsque la piste de référence 28 est raccordée, par augmentation locale de la conductivité du support 12, avec la borne 20 raccordée à la masse M, le potentiel de la piste de référence 28 diminue.

L'invention permet de détecter une élévation de la conductivité du support 12 en suivant les variations du potentiel de la piste 28.

Ainsi, l'invention tire profit de la propriété d'augmentation de la conductivité du support 12 avec la température et de ce fait, les moyens de détection sont peu encombrants et simples.

En variante, le support 12 peut porter plusieurs composants 14.

Dans ce cas, afin de surveiller un groupe de composants 14 susceptibles de provoquer accidentellement un échauffement indésirable de plusieurs zones sensibles Z, les moyens de détection peuvent comprendre plusieurs moyens sensibles 26 à l'élévation de la conductivité du support 12 avec la température, associés respectivement aux différentes zones sensibles Z du support 12.

Eventuellement, afin de limiter la densité de composants électroniques, notamment des moyens sensibles 26, sur le support 12 du circuit imprimé 10, le premier élément conducteur de référence 28 de chacun des moyens sensibles 26 peut comprendre plusieurs branches s'étendant respectivement dans les différentes zones sensibles Z.

De ce fait, des mêmes moyens sensibles 26 peuvent surveiller un groupe de composants 14.

De préférence, chacun des moyens sensibles 26 est destiné à être raccordé à des moyens informatiques afin notamment d'identifier le groupe de composants 14 ou le composant 14 responsable d'un échauffement indésirable d'une zone sensible Z du support 12.

## Revendications

1. Circuit imprimé (10) du type comprenant un support (12), isolant dans les conditions normales de fonctionnement du circuit imprimé (10), portant au moins un composant (14) susceptible de provoquer accidentellement un échauffement indésirable d'une zone sensible (Z) du support (12), et des moyens de détection de l'échauffement de la zone sensible (Z), **caractérisé en ce que** les moyens de détection comprennent des moyens (26) sensibles à l'élévation de la conductivité du support (12) avec la température, comprenant:
- un premier élément conducteur (28) s'étendant sur le support (12), dit élément conducteur de référence, porté, dans les conditions normales de fonctionnement du circuit imprimé (10), à un potentiel de référence (Vref),
- au moins un second élément conducteur (20, 22, 24) s'étendant sur le support (12) porté à un potentiel différent du potentiel de référence (Vref), les premier (28) et second (20, 22, 24) éléments conducteurs s'étendant au moins partiellement dans la zone sensible (Z) et,
- des moyens (30) de mesure du potentiel du premier élément conducteur (28).

2. Circuit imprimé (10) selon la revendication précédente, dans lequel le second élément conducteur (20, 22, 24) est une piste (22) d'alimentation du composant (14) portée à un potentiel (Vcc) d'alimentation du composant (14).

3. Circuit imprimé (10) selon la revendications précédente, dans lequel le composant (14) comporte une semelle formant borne d'alimentation soudée sur la piste d'alimentation (22).

4. Circuit imprimé (10) selon la revendication 2 ou 3, dans lequel l'élément conducteur de référence (28) s'étend longitudinalement entre un bord rectiligne de la piste d'alimentation (22) et une rangée (R2) de broches de connexion (24) du composant (14).

5. Circuit imprimé (10) selon l'une quelconque des revendications précédentes, dans lequel les moyens sensibles (26) comprennent des moyens (32) de comparaison du potentiel du premier élément conducteur (28) avec le potentiel de référence (Vref).

6. Circuit imprimé (10) selon l'une quelconque des revendications précédentes, dans lequel le potentiel de référence (Vref) est égal à la moitié du potentiel d'alimentation (Vcc) du composant électronique (14).

7. Circuit imprimé (10) selon l'une quelconque des revendications précédentes, le support (12) portant un groupe de composants (14) susceptibles de provoquer accidentellement un échauffement de plusieurs zones sensibles (Z), dans lequel le premier élément conducteur de référence (28) comprend plusieurs branches s'étendant respectivement dans les différentes zones sensibles (Z) du support (12).

8. Circuit imprimé (10) selon l'une quelconque des revendications précédentes, dans lequel le support (12) est formé dans un matériau comprenant de la résine époxy.

9. Circuit imprimé (10) selon l'une quelconque des revendications précédentes, dans lequel le composant (14) est un commutateur de puissance intelligent comprenant des première (R1) et seconde (R2) rangées de broches de connexion, la première rangée (R1) comprenant des broches d'entrée (16) et la seconde rangée (R2) comprenant des broches de sortie (24), la zone sensible (Z) s'étendant plus près de la seconde rangée (R2) que de la première rangée (R1).

10. Circuit imprimé (10) selon l'une quelconque des revendications précédentes, dans lequel le second élément est un élément conducteur formant une broche (20) de connexion du composant (14) à une masse (M) ou une broche de sortie (24).

11. Circuit imprimé (10) selon l'une quelconque des revendications précédentes, le support (12) portant un groupe de composants (14) susceptibles de provoquer accidentellement un échauffement de plusieurs zones sensibles (Z), dans lequel les moyens de détection comprennent plusieurs moyens (26) sensibles à l'élévation de la conductivité du support (12) avec la température associés respectivement aux différentes zones sensibles (Z) du support (12).

12. Circuit imprimé (10) selon la revendication 7 ou 11, dans lequel chacun des moyens sensibles (26) à l'élévation de la conductivité du support (12) est destiné à être raccordé à des moyens informatiques afin notamment d'identifier, parmi les différents composants (14) portés par le circuit imprimé (10), le groupe de composants (14) ou le composant (14) qui est responsable d'un échauffement indésirable d'une zone du support (12).

## Claims

1. Printed circuit (10) of the type comprising a board (12) that is insulating under the normal operating conditions of the printed circuit (10), bearing at least one component (14) liable to accidentally cause undesirable heating of a sensitive zone (Z) of the board (12), and means for detecting the heating of the sensitive zone (Z), **characterized in that** the detecting means comprise means (26) sensitive to the increase in the conductivity of the board (12) with temperature, comprising:
- a first conductive element (28) extending over the board (12), called a reference conductive element, brought, under the normal operating conditions of the printed circuit (10), to a reference potential (Vref);
- at least one second conductive element (20, 22, 24) extending over the board (12) brought to a different potential to the reference potential (Vref), the first (28) and second (20, 22, 24) conductive elements extending at least partially into the sensitive zone (Z); and
- means (30) for measuring the potential of the first conductive element (28).

2. Printed circuit (10) according to the preceding claim, in which the second conductive element (20, 22, 24) is a track (22) for supplying power to the component (14), which track is brought to a supply potential (Vcc) of the component (14).

3. Printed circuit (10) according to the preceding claim, in which the component (14) comprises a base forming a supply terminal soldered to the supply track (22).

4. Printed circuit (10) according to either of Claims 2 and 3, in which the reference conductive element (28) extends longitudinally between one rectilinear edge of the supply track (22) and a row (R2) of pins (24) for connecting the component (14).

5. Printed circuit (10) according to any one of the preceding claims, in which the sensitive means (26) comprise means (32) for comparing the potential of the first conductive element (28) with the reference potential (Vref).

6. Printed circuit (10) according to any one of the preceding claims, in which the reference potential (Vref) is equal to half the supply potential (Vcc) of the electronic component (14).

7. Printed circuit (10) according to any one of the preceding claims, the board (12) bearing a group of components (14) that are liable to accidentally cause heating of a plurality of sensitive zones (Z), in which the first reference conductive element (28) comprises a plurality of branches extending, respectively, into the various sensitive zones (Z) of the board (12).

8. Printed circuit (10) according to any one of the preceding claims, in which the board (12) is made of a material comprising epoxy resin.

9. Printed circuit (10) according to any one of the preceding claims, in which the component (14) is a smart power switch comprising first (R1) and second (R2) rows of connection pins, the first row (R1) comprising input pins (16) and the second row (R2) comprising output pins (24), the sensitive zone (Z) lying closer to the second row (R2) than to the first row (R1).

10. Printed circuit (10) according to any one of the preceding claims, in which the second element is a conductive element forming a pin (20) connecting the component (14) to a ground plane (M), or an output pin (24).

11. Printed circuit (10) according to any one of the preceding claims, the board (12) bearing a group of components (14) liable to accidentally cause heating of a plurality of sensitive zones (Z), in which the detecting means comprise a plurality of means (26) sensitive to the increase in the conductivity of the board (12) with temperature, respectively associated with the various sensitive zones (Z) of the board (12).

12. Printed circuit (10) according to either of Claims 7 and 11, in which each one of the means (26) sensitive to the increase in the conductivity of the board (12) is intended to be connected to computing means especially in order to identify, among the various components (14) borne by the printed circuit (10), the group of components (14) or the component (14) that is responsible for undesirable heating of a zone of the board (12).

## Patentansprüche

1. Gedruckte Schaltung (10) des Typs, die einen Träger (12), der unter normalen Betriebsbedingungen der gedruckten Schaltung (10) isoliert und wenigstens eine Komponente (14) trägt, die zufällig eine unerwünschte Erwärmung einer empfindlichen Zone (Z) des Trägers (12) hervorrufen kann, und Mittel zum Detektieren der Erwärmung der empfindlichen Zone (Z) umfasst, **dadurch gekennzeichnet, dass** die Detektionsmittel Mittel (26) umfassen, die auf eine Erhöhung der spezifischen Leitfähigkeit des Trägers (12) mit der Temperatur ansprechen, mit:
- einem erstem Leiterelement (28), das sich auf dem Träger (12) erstreckt und das Referenzleiterelement genannt wird, das unter normalen Betriebsbedingungen der gedruckten Schaltung (10) auf einem Referenzpotential (Vref) gehalten wird,
- wenigstens einem zweiten Leiterelement (20, 22, 24), das auf dem Träger (12) verläuft und auf einem von dem Referenzpotential (Vref) verschiedenen Potential gehalten wird, wobei das erste Leiterelement (28) und das zweite Leiterelement (20, 22, 24) wenigstens teilweise in der empfindlichen Zone (Z) verlaufen, und
- Mitteln (30) zum Messen des Potentials des ersten Leiterelements (28).

2. Gedruckte Schaltung (10) nach dem vorhergehenden Anspruch, wobei das zweite Leiterelement (20, 22, 24) eine Versorgungsbahn (22) für die Komponente (14) ist, die auf einem Versorgungspotential (Vcc) der Komponente (14) gehalten wird.

3. Gedruckte Schaltung (10) nach dem vorhergehenden Anspruch, wobei die Komponente (14) einen Fuß aufweist, der einen Versorgungsanschluss bildet, der mit der Versorgungsbahn (22) verschweißt ist.

4. Gedruckte Schaltung (10) nach Anspruch 2 oder 3, wobei sich das Referenzleiterelement (28) in Längsrichtung zwischen einer geradlinigen Kante der Versorgungsbahn (22) und einer Reihe (R2) von Verbindungsanschlüssen (24) der Komponente (14) erstreckt.

5. Gedruckte Schaltung (10) nach einem der vorhergehenden Ansprüche, wobei die ansprechenden Mittel (26) Mittel (32) zum Vergleichen des Potentials des ersten Leiterelements (28) mit dem Referenzpotential (Vref) umfassen.

6. Gedruckte Schaltung (10) nach einem der vorhergehenden Ansprüche, wobei das Referenzpotential (Vref) gleich der Hälfte des Versorgungspotentials (Vcc) der elektronischen Komponente (14) ist.

7. Gedruckte Schaltung (10) nach einem der vorhergehenden Ansprüche, wobei der Träger (12) eine Gruppe von Komponenten (14) trägt, die zufällig eine Erwärmung mehrerer empfindlicher Zonen (Z) hervorrufen können, wobei das erste Referenzleiterelement (28) mehrere Schenkel umfasst, die sich in den jeweiligen verschiedenen empfindlichen Zonen (Z) des Trägers (12) erstrecken.

8. Gedruckte Schaltung (10) nach einem der vorhergehenden Ansprüche, wobei der Träger (12) aus einem Material gebildet ist, das Epoxidharz enthält.

9. Gedruckte Schaltung (10) nach einem der vorhergehenden Ansprüche, wobei die Komponente (14) ein intelligenter Leistungskommutator ist, der eine erste Reihe (R1) und eine zweite Reihe (R2) von Verbindungsanschlüssen enthält, wobei die erste Reihe (R1) Eingangsanschlüsse (16) enthält und die zweite Reihe (R2) Ausgangsanschlüsse (24) enthält, wobei die empfindliche Zone (Z) näher bei der zweiten Reihe (R2) als bei der ersten Reihe (R1) verläuft.

10. Gedruckte Schaltung (10) nach einem der vorhergehenden Ansprüche, wobei das zweite Element ein Leiterelement ist, das einen Verbindungsanschluss (20) der Komponente (14) mit Masse (M) oder mit einem Ausgangsanschluss (24) bildet.

11. Gedruckte Schaltung (10) nach einem der vorhergehenden Ansprüche, wobei der Träger (12) eine Gruppe von Komponenten (14) trägt, die zufällig eine Erwärmung mehrerer empfindlicher Zonen (Z) hervorrufen können, wobei die Detektionsmittel mehrere Mittel (26) umfassen, die auf eine Erhöhung der spezifischen Leitfähigkeit des Trägers (12) mit der Temperatur ansprechen und die den verschiedenen empfindlichen Zonen (Z) des Trägers (12) zugeordnet sind.

12. Gedruckte Schaltung (10) nach Anspruch 7 oder 11, wobei jedes der Mittel (26), die auf eine Erhöhung der spezifischen Leitfähigkeit des Trägers (12) ansprechen, dazu bestimmt ist, mit Datenverarbeitungsmitteln verbunden zu werden, um insbesondere unter den verschiedenen Komponenten (14), die von der gedruckten Schaltung (10) getragen werden, die Gruppe von Komponenten (14) oder die Komponente (14), die für eine unerwünschte Erwärmung einer Zone des Trägers (12) verantwortlich ist, zu identifizieren.
